Europäisches Patentamt

European Patent Office

Office européen des brevets

(11) Publication number: **0 243 170 B1**

# EUROPEAN PATENT SPECIFICATION

(45) Date of publication of patent specification: **22.01.92**

(51) Int. Cl.⁵: **H01L 31/12**, G02B 1/10, //G11B7/12,G11B7/09, H01L33/00

(21) Application number: **87303534.9**

(22) Date of filing: **22.04.87**

(54) Semiconductor laser apparatus.

(30) Priority: **23.04.86 JP 92410/86**

(43) Date of publication of application:
**28.10.87 Bulletin 87/44**

(45) Publication of the grant of the patent:
**22.01.92 Bulletin 92/04**

(84) Designated Contracting States:
**DE FR GB IT NL**

(56) References cited:
**EP-A- 0 029 755**
**GB-A- 2 165 694**

**IBM TECHNICAL DISCLOSURE BULLETIN, vol. 20, no. 5, October 1977, pages 2089-2090, New York, US; J.D. CROW: "Integral source/receiver package for optical data"**

**PATENT ABSTRACTS OF JAPAN, vol. 9, no. 106 (E-313)[1829], 10th May 1985; & JP-A-59 232 477**

**PATENT ABSTRACTS OF JAPAN, vol. 5, no. 163 (E-78)[835], 20th October 1981, page 152**

**E 78; & JP-A-56 93 388**

(73) Proprietor: **SONY CORPORATION**
**7-35 Kitashinagawa 6-Chome Shinagawa-ku Tokyo 141(JP)**

(72) Inventor: **Yoshitoshi, You**
**c/o P.D. Sony Corporation 6-7-35 Kitashinagawa**
**Shinagawa-ku Tokyo 141(JP)**
Inventor: **Matsumoto, Yoshiyuki**
**c/o P.D. Sony Corporation 6-7-35 Kitashinagawa**
**Shinagawa-ku Tokyo 141(JP)**

(74) Representative: **Thomas, Christopher Hugo et al**
**D Young & Co 10 Staple Inn**
**London WC1V 7RD(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to semiconductor laser apparatus. Embodiments of the invention may be used in an optical head for performing laser beam radiation and incident laser beam detection.

An optical head used in an optical recording and/or reproducing system irradiates an optical recording medium with a light beam, and detects a modulated light beam from the recording medium to perform information recording or reproducing.

The optical head normally uses a semiconductor laser apparatus. Namely, a laser light beam radiated from a semiconductor laser and reflected by a beam splitter is incident on an optical recording medium through an objective lens. The beam, reflected by the recording medium and passing through the objective lens and the beam splitter, is incident on a photodetector.

In the optical head, the semiconductor laser, the beam splitter and the photodetector form a semiconductor laser apparatus, and the positional adjustment of the three separate optical components results in a high cost for the optical head.

Our European patent specification EP-A-0 199 565 proposes a solution to this problem in which a laser diode forming a light source and a plurality of photodetectors for detecting light reflected by an optical disc are formed on a semiconductor substrate. Moreover, on the semiconductor substrate, there is fixed a prism positioned above the photodetectors for introducing the reflected light from the optical disc to the photodetectors. In this way, it is possible to reduce the size of the optical head as well as to simplify its structure, so reducing the cost. However, stray light incident from a semitransparent reflecting plane, that is, a direct light from the laser diode, is incident on the photodetectors, so that the detecting sensitivity of the photodetectors is decreased and the detecting error is increased.

According to the present invention there is provided a semiconductor laser apparatus of an optical head, the apparatus comprising:
a semiconductor substrate;
a semiconductor laser diode mounted on said substrate for radiating a laser beam;
a photodetector formed on said substrate;
a prism mounted on said substrate so as to overlie said photodetector, said prism having a first plane for directing said laser beam to a reflecting object and directing a laser beam reflected by said reflecting object to said photodetector, and a second plane facing said photodetector; and
a coating formed on a boundary between said substrate and said prism;
characterized in that:
said coating is formed of a plurality of layers, each of which has a different refractive index, whereby laser light incident from said first plane other than said laser beam reflected by said reflecting object is inhibited from reaching said photodetector.

The invention will now be described by way of example with reference to the accompanying drawings, throughout which like parts are referred to by like references, and in which:
Figure 1 is an enlarged cross-sectional view showing part of an embodiment of semiconductor laser apparatus according to the present invention;
Figure 2 is an enlarged cross-sectional view of a part of Figure 1 showing first and second coating layers;
Figure 3 is a graph showing the relationship between an incident angle of a laser beam and its transmittance; and
Figures 4, 5 and 6 are graphs respectively showing the relationship between the incident angle of a laser beam and its transmittance when the thicknesses of the first and second coating layers are varied.

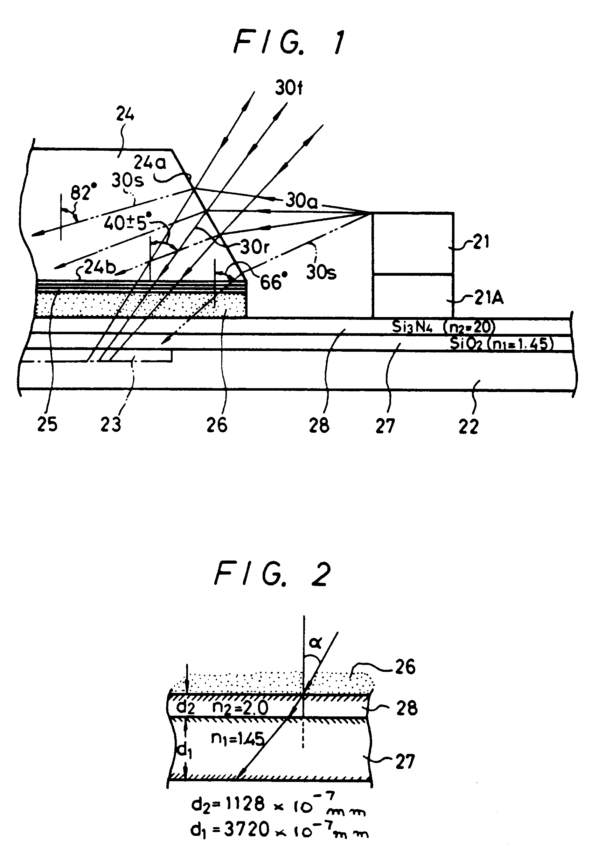

Referring to the embodiment of Figure 1, a semiconductor laser apparatus comprises a semiconductor substrate 22 made, for example, of silicon, a semiconductor laser diode 21 fixed on the semiconductor substrate 22 by a solder 21A, a photodetector section 23 formed on the substrate 22, and a prism 24 which is located on the photodetector section 23 and has a first semitransparent reflecting plane 24a facing the laser diode 21 and an optical disc (not shown) at a predetermined angle and a plane 24b facing the photodetector section 23. Although only one photodetector section 23 is shown in Figure 1, there are actually three photodetectors formed on the semiconductor substrate 22.

On the plane 24b, that is the bottom plane of the prism 24, a half-mirror 25 is formed by multicoating which forms a second semitransparent reflecting plane of the prism 24. On the upper surface of the semiconductor substrate 22 there are formed a first coating layer 27 made of $SiO_2$ and a second coating layer 28 made of $Si_3N_4$. The half-mirror 25 is adhered to the second coating layer 28 by a bonding agent 26.

The refractive index n of the bonding agent 26 is selected to be almost equal to that of the prism 24, for example 1.56. The refractive index n1 of the first coating layer 27 and the refractive index n2 of the second reflective layer 28 are respectively 1.45 and 2.0.

The thickness d1 of the first coating layer 27 is $3720 \times 10^{-7}$ mm and the thickness d2 of the second coating layer 28 is $1128 \times 10^{-7}$ mm.

The first and second coating layers 27 and 28 are respectively formed, for example, by vacuum evaporation techniques with the predetermined thickness after the photodetector section 23 and so on are formed on the semiconductor substrate 22.

The main portion of the semiconductor laser apparatus is constituted as described above, so that a laser beam 30a radiated from the laser diode 21 is reflected by the semitransparent reflecting plane 24a in front of the prism 24 and irradiated on an optical disc (not shown), as a laser beam 30f. A returning laser beam 30r reflected by the optical disc passes through the same optical path, enters the prism 24 through the first semitransparent reflecting plane 24a and irradiates the photodetector section 23 through the first and second coating layers 27 and 28, although a portion of the returning laser beam 30r is reflected by the half-mirror 25 on the bottom plane of the prism 24 at an incident angle of $40° \pm 5°$.

On the other hand, a portion of the laser beam 30a radiated from the laser diode 21 passes through the semitransparent reflecting plane 24a of the prism 24 and enters the prism 24 as stray laser light 30s as indicated by a two-dot chain line in Figure 1. The incident angle thereof at that time is made to be approximately from $66°$ to $82°$.

Incidentally, since the first and second coating layers 27 and 28 are formed on the boundary between the semiconductor substrate 22 and the prism 24, as will be later described, it is possible that the stray laser light 30s is almost totally reflected by the first and second reflecting layers 27 and 28, and thereby does not reach the photodetector section 23.

Figure 2 shows how the laser light ($7800 \times 10^{-7}$ mm) passes through the coating layers 27 and 28 when the coating layer 27 is made $SiO_2$, the reflective index n1 of which is 1.45 and the thickness of which is $3720 \times 10^{-7}$ mm, and the coating layer 28 is made of $Si_3N_4$, the refractive index of which is 2.0 and the thickness of which is selected as $1128 \times 10^{-7}$ mm.

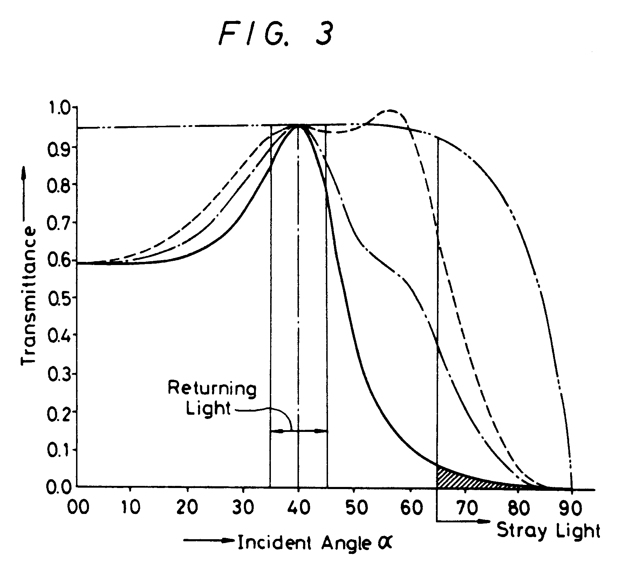

Figure 3 shows the relationship between the transmittance of the laser light and its incident angle $\alpha$, wherein ordinates represent the transmittance and abscissae the incident angle $\alpha$.

In Figure 3, as shown by a solid line curve, a transmittance of more than 90% is presented for the laser light, the incident angle $\alpha$ of which is $40° \pm 5°$, that is, the returning laser beam 30r from the optical disc, while for the stray laser light 30s, the incident angle of which is $66°$ or more, the transmittance is reduced to less than several %, that is, the stray laser light 30s is subjected to almost total reflection by the two coating layers 27 and 28.

Therefore, the photodetector section 23 presents a high sensitivity to the returning laser beam 30r, but responds little to the stray laser light 30s, so that it is possible to detect the information contained in the reflected laser light from the optical disc with a high sensitivity.

The above data in the graph of Figure 3 is made for a so-called S-polarized light of the laser light, the plane of polarization of which is in the direction perpendicular to the plane of incidence. A broken line curve in Figure 3 represents the data for a P-polarized light of the laser light. A one-dot chain line curve shows average data between those for the P and S-polarized light. Thus, the variation in the transmittance with respect to the incident angle $\alpha$ shows nearly the same tendency as above when average data of S-polarized light data and P-polarized light data are concerned.

In addition, the characteristic shown by a fine one-dot chain line in Figure 3 shows the case where a single coating layer only is formed on the substrate 22 without the first coating layer 27 (or d1 = 0). In this case, it can be seen that the transmittance scarcely varies as the incident angle $\alpha$ changes up to $70°$, so the photodetector does not preferentially select the returning laser light.

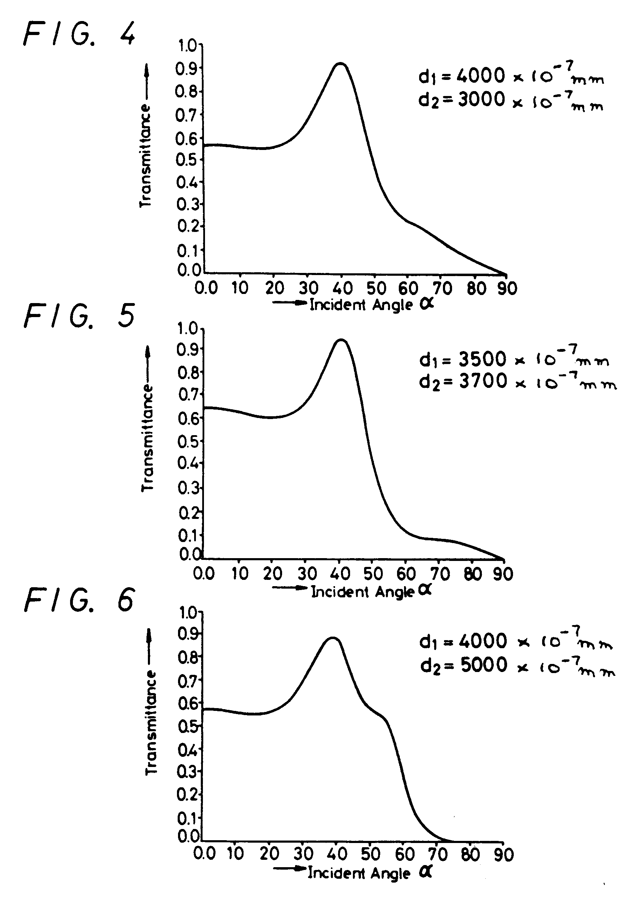

Figures 4, 5 and 6 show the characteristics of the transmittance depending upon the incident angle $\alpha$ of the laser light when the thicknesses d1 and d2 of the first and second coating layers 27 and 28 are varied.

In these cases, the ratio of the transmittance for the returning laser light to that for the stray laser light is inferior compared with that of the embodiment of Figure 3. However, the selecting effect on the returning laser light is enhanced and the sensitivity of the photodetector section can be improved as compared with the case where no coating layer is provided or a single coating layer is provided. Thus, when an embodiment of the present invention is used as an optical head, it is possible to detect a tracking error signal, a focus error signal and so on with high accuracy.

**Claims**

1.  A semiconductor laser apparatus of an optical head, the apparatus comprising:
    a semiconductor substrate (22);
    a semiconductor laser diode (21) mounted on said substrate (22) for radiating a laser beam (30a);
    a photodetector (23) formed on said substrate (22);
    a prism (24) mounted on said substrate (22) so as to overlie said photodetector (23), said prism (24) having a first plane (24a) for directing said laser beam (30a) to a reflecting object and directing a laser beam (30r) reflected by said reflecting object to said photodetector (23), and a second plane (24b) facing said photodetector (23); and

a coating (27, 28) formed on a boundary between said substrate (22) and said prism (24); characterized in that:

said coating (27, 28) is formed of a plurality of layers (27, 28), each of which has a different refractive index, whereby laser light incident from said first plane (24a) other than said laser beam (30r) reflected by said reflecting object is inhibited from reaching said photodetector (23).

2. Apparatus according to claim 1 wherein said plurality of layers (27, 28) consists of two layers (27, 28), a first layer (27) of SiO$_2$ and a second layer (28) of Si$_3$N$_4$.

3. Apparatus according to claim 2 wherein said first layer (27) is thicker than said second layer (28) and is formed on said semiconductor substrate (22).

4. Apparatus according to claim 1, claim 2 or claim 3 wherein said first plane (24a) and said second plane (24b) of said prism (24) are respective half-mirrors.

## Revendications

1. Dispositif laser à semiconducteur d'une tête optique, le dispositif comprenant :

un substrat semiconducteur (22) ;

une diode laser à semiconducteur (21) montée sur ledit substrat (22) pour irradier un faisceau laser (30a) ;

un photodétecteur (23) formé sur ledit substrat (22) ;

un prisme (24) monté sur ledit substrat (22) de manière à recouvrir ledit photodétecteur (23), ledit prisme (24) ayant un premier plan (24a) pour diriger ledit faisceau laser (30a) vers un objet réfléchissant et pour diriger un faisceau laser (30r) réfléchi par ledit objet réfléchissant vers ledit photodétecteur (23), et un second plan (24b) qui fait face audit photodétecteur (23) ; et

un revêtement (27, 28) formé sur une frontière entre ledit substrat (22) et ledit prisme (24) ;

caractérisé en ce que :

ledit revêtement (27, 28) est constitué d'une pluralité de couches (27, 28) dont chacune a un indice de réfraction différent et ainsi, une lumière laser incidente qui provient dudit premier plan (24a) autre que ledit faisceau laser (30r) réfléchi par ledit objet réfléchissant est empêchée d'atteindre ledit photodétecteur (23).

2. Dispositif selon la revendication 1, dans lequel ladite pluralité de couches (27, 28) est constituée par deux couches (27, 28), une première couche (27) en SiO$_2$ et une seconde couche (28) en Si$_3$N$_4$.

3. Dispositif selon la revendication 2, dans lequel ladite première couche (27) est plus épaisse que ladite seconde couche (28) et est formée sur ledit substrat semiconducteur (22).

4. Dispositif selon la revendication 1, 2 ou 3, dans lequel ledit premier plan (24a) et ledit second plan (24b) dudit prisme (24) sont des demi-miroirs respectifs.

## Patentansprüche

1. Halbleiterlaser-Vorrichtung eines optischen Kopfes, welche Vorrichtung umfaßt:

ein Halbleiter-Substrat (22),

eine Halbleiterlaser-Diode (21), die auf dem Substrat (22) zum Abstrahlen eines Laserstrahls (30a) montiert ist,

einen Photodetektor (23), der auf dem Substrat (22) ausgebildet ist,

ein Prisma (24), das auf dem Substrat (22) derart montiert ist, daß es über dem Photodetektor (23) liegt, wobei das Prisma (24) aufweist: eine erste Ebene (24a) zum Richten des Laserstrahls (30a) auf ein reflektierendes Objekt und zum Richten eines Laserstrahls (30r), der von dem reflektierenden Objekt reflektiert ist, auf den Photodetektor (23), und eine zweite Ebene (24b), die dem Photodetektor (23) gegenüberliegt, und

eine Beschichtung (27, 28), die auf einer Grenzfläche zwischen dem Substrat (22) und dem Prisma (24) ausgebildet ist,

dadurch **gekennzeichnet,** daß

die Beschichtung (27, 28) aus einer Vielzahl von Lagen (27, 28) gebildet ist, die unterschiedliche Brechungsindizes haben, wodurch Laserlicht, das von der ersten Ebene (24a) einfällt, anders als der Laserstrahl (30r), der durch das reflektierende Objekt reflektiert ist, daran gehindert wird, den Photodetektor (23) zu erreichen.

2. Vorrichtung nach Anspruch 1, bei der die Vielzahl von Lagen (27, 28) aus zwei Lagen (27, 28), nämlich einer ersten Lage (27) aus SiO$_2$ und einer zweiten Lage (28) aus Si$_3$N$_4$ besteht.

3. Vorrichtung nach Anspruch 2, bei der die erste Lage (27) dicker als die zweite Lage (28) ist und auf dem Halbleiter-Substrat (22) ausgebildet ist.

4. Vorrichtung nach Anspruch 1, 2 oder 3, bei der die erste Ebene (24a) und die zweite Ebene (24b) des Prismas (24) jeweilige Halbspiegel sind.

## FIG. 1

## FIG. 2

$$d_2 = 1128 \times 10^{-7} mm$$
$$d_1 = 3720 \times 10^{-7} mm$$

# FIG. 3

**FIG. 4**

$d_1 = 4000 \times 10^{-7} mm$
$d_2 = 3000 \times 10^{-7} mm$

Transmittance vs Incident Angle $\alpha$

**FIG. 5**

$d_1 = 3500 \times 10^{-7} mm$
$d_2 = 3700 \times 10^{-7} mm$

Transmittance vs Incident Angle $\alpha$

**FIG. 6**

$d_1 = 4000 \times 10^{-7} mm$
$d_2 = 5000 \times 10^{-7} mm$

Transmittance vs Incident Angle $\alpha$